Europäisches Patentamt

European Patent Office

Office européen des brevets

(11) Veröffentlichungsnummer: **0 336 381**
**A2**

## (12) EUROPÄISCHE PATENTANMELDUNG

(21) Anmeldenummer: 89105909.9

(22) Anmeldetag: 04.04.89

(51) Int. Cl.⁴: **H02J 7/10 , G01R 31/00**

(30) Priorität: 05.04.88 DE 3811371

(43) Veröffentlichungstag der Anmeldung:
**11.10.89 Patentblatt 89/41**

(84) Benannte Vertragsstaaten:
**AT BE CH DE ES FR GB IT LI LU NL SE**

(71) Anmelder: **HABRA ELEKTRONIK GMBH**
**Meglingerstrasse 48**
**D-8000 München 71(DE)**

(72) Erfinder: **Hauser, Franz**
**Ziehrerstrasse 1**
**D-8025 Unterhaching(DE)**

(74) Vertreter: **Patentanwälte Grünecker,**
**Kinkeldey, Stockmair & Partner**
**Maximilianstrasse 58**
**D-8000 München 22(DE)**

(54) **Verfahren zum Laden und gleichzeitigen Prüfen des Zustandes eines Nickelcadmium-Akkumulators.**

(57) Es wird ein Verfahren zum Laden und gleichzeitigen Prüfen des Zustandes eines Nickelcadmium-Akkumulators angegeben, bei dem in den Ladezyklus Meßphasen mit Entladeintervallen vergleichsweise kurzer Dauer eingeschoben sind. Während der Meßphasen wird der Innenwiderstand des Akkumulators unter unterschiedlichen Lade- und Entladezuständen gemessen, die Innenwiderstände werden zueinander in Beziehung gesetzt und auch mit in aufeinanderfolgenden Meßphasen ermittelten Innenwiderständen verglichen. Aus diesen Beziehungen wird eine Fülle von Informationen über verschiedene Zustände des Akkumulators abgeleitet, mit deren Hilfe der Ladevorgang gesteuert und eine Aussage über den Brauchbarkeitszustand des Akkumulators gewonnen werden kann.

EP 0 336 381 A2

## Verfahren zum Laden und gleichzeitigen Prüfen des Zustandes eines Nickelcadmium-Akkumulators

Die Erfindung bezieht sich auf ein Verfahren zum Laden und gleichzeitigen Prüfen des Zustandes eines Nickelcadmium-Akkumulators mit einem pulsierenden Ladegleichstrom rechteckigen Impulsverlaufs, der Abschnitte kleiner Stromstärke und Abschnitte hoher Stromstärke aufweist, und mit zyklisch eingeschobenen Meßphasen mit Entladeintervallen vergleichsweise kurzer Dauer, wobei zu Beginn und im vorgegebenen zeitlichen Abstand nach Beginn der Abschnitte hoher Stromstärke jeweils die Akkumulatorspannung gemessen und die Differenz der gemessenen Spannungswerte zur Steuerung des Ladevorgangs verwendet wird. Ein Verfahren dieser Art ist in der EP-PS 0 034 003 beschrieben.

Gemäß dieser Druckschrift wird die Änderung der Batteriespannung während des Ladens über eine vorgegebene Zeit während eines Teils eines Ladeimpulses oder während eines Teils einer Entladeperiode gemessen. Der Ladevorgang wird abgebrochen, wenn ein Parameter der gemessenen Spannung eine vorgegebene Charakteristik überschreitet, beispielsweise die Spannung einen Grenzwert überschreitet. Weiterhin ist beschrieben, daß die Änderung der Batteriespannung während einer Periode gemessen wird, die mit dem Beginn eines Ladeimpulses beginnt. Beispielsweise wird unmittelbar bei Beginn eines Ladeimpulses und zwei Sekunden später die Batteriespannung gemessen. Ist der Akkumulator vollgeladen, dann ist diese Differenz sehr groß. Trägt man die gemessenen Spannungsdifferenzwerte in einem Zeitdiagramm auf, dann erkennt man, daß die Steigung dieser sich ergebenden Kurve kurz vor Erreichen des vollen Ladezustandes des Akkumulators einen Umkehrpunkt hat, was sich als ein Kriterium zum Abbrechen des Ladevorgangs anbietet, da dieser Effekt unabhängig von der Temperatur des Akkumulators ist, die im übrigen starken Einfluß auf die genannte Spannungsdifferenz als solche hat.

Das Überladen eines Nickelcadmiumakkumulators ist nicht die einzige kritische Situation für einen solchen Akkumulator. Beispielsweise darf ein aus Massezellen bestehender Akkumulator nicht schnellgeladen werden, ein tiefgekühlter Akkumulator darf nur sehr langsam geladen werden, ein tiefentladener Akkumulator muß vor dem eigentlichen Ladevorgang erst formiert werden, es muß auf die richtige Polung geachtet werden und dergleichen. Weiterhin ist zu beachten, daß Nickelcadmiumakkumulatoren außer den schon erwähnten Zuständen auch andere Zustände zeigen, die beim Laden berücksichtigt werden müssen. Beispielsweise ist das Laden eines verbrauchten Akkumulators nicht mehr lohnend, diesen scheidet man besser aus, gleiches gilt für einen Akkumulator, der einen Zellenschluß aufweist. Es ist weiterhin bekannt, daß Nickelcadmiumakkumulatoren einen sog. Memory-Effekt zeigen können. Damit ist gemeint, daß ein Akkumulator, der über lange Zeit nur schwach belastet oder geladen worden ist, zwar noch immer auf seine volle Kapazität aufgeladen werden kann, er aber dennoch nicht in der Lage ist, bei starken Belastungen entsprechend viel Strom abzugeben. Solche Fälle liegen beispielsweise vor bei Akkumulatoren von Funksprechgeräten, die über lange Zeit im Standby betrieben werden und nur kurze Zeit auf Sendebetrieb geschaltet werden. Besonders kritisch ist dieser Memory-Effekt auch bei Akkumulatoren, die der Notstromversorgung dienen, beispielsweise im medizinisch-technischen Bereich. Solche Zustände sollten daher ebenfalls erfaßt werden können.

Der Erfindung liegt die Aufgabe zugrunde, ein Verfahren der eingangs genannten Art anzugeben, mit welchem während des Ladebetriebs, zu welchem auch zwischengeschaltete Entladeperioden gehören, Aussagen vielfältigster Art über den Zustand des Akkumulators gewonnen werden können, die über die Aussage hinsichtlich des Ladezustandes hinausgehen.

Diese Aufgabe wird durch die kennzeichnenden Merkmale des Anspruchs 1 gelöst. Vorteilhafte Ausgestaltungen der Erfindung sind Gegenstand der Unteransprüche.

Der Erfindung liegt die Erkenntnis zugrunde, daß unter den verschiedensten Lade- und Entladebedingungen ermittelte Innenwiderstände des Akkumulators im Verhältnis zueinander und in ihrer zeitlichen Entwicklung während des Ladevorgangs aufschlußreiche Analysen über den Zustand des Akkumulators ermöglichen, die über die reine Ladezustandsermittlung weit hinausgehen. Die Erfindung sieht daher vor, daß die Spannung am Akkumulator in einer Meßphase unter verschiedenartigsten Betriebszuständen erfaßt, gespeichert und auch unter Berücksichtigung der jeweiligen Ladestromstärken ausgewertet wird. Mit Hilfe der Erfindung ist es z.B. möglich, aufgrund akkumulatorspezifischer Vorgaben den relativen Ladezustand zu ermitteln. Auch ist es möglich, die Ist-Kapazität des Akkumulators zu ermitteln. In der Praxis wird ein Akkumulator als unbrauchbar ausgesondert, wenn seine Ist-Kapazität auf einen vorbestimmten Prozentsatz, der beispielsweise zwischen 60 und 80% liegt, seiner Nennkapazität abgesunken ist.

Das Laden, insbesondere das Schnelladen eines tiefgekühlten Nickelcadmiumakkumulators ist für diesen gefährlich. Es gibt zwar Akkumulatoren, die mit Temperatursensoren ausgerüstet sind, die hauptsächlich zum Zwecke vorgesehen sind, den Ladevorgang abzubrechen, da bekannt ist, daß die Temperatur eines Nickelcadmiumakkumulators unter normalen Umgebungsbedingungen ein brauchbarer Hinweis für die Ermittlung des Ladezustandes ist, so daß es vorstellbar ist, mit einem solchen Temperatursensor auch den tiefgekühlten Zustand des Akkumulators zu ermitteln und davon gesteuert das Ladeprogramm entsprechend einzurichten, doch versagt diese Methode dort, wo, wie in vielen Fällen, solche Temperatursensoren nicht vorhanden sind. Die Erfindung schafft auch diesbezüglich Abhilfe, da sie aus dem Zusammenhang der unter verschiedenen Ladebetriebszuständen ermittelten Innenwiderstände einen Rückschluß auf die aktuelle Temperatur des Akkumulators zuläßt.

Ähnliches gilt für einen tiefentladenen Akkumulator. Ein solcher Akkumulator zeigt beim Aufladen mit üblichem Ladestrom sehr schnell Effekte, die denen am Ende des Ladevorgangs beim Volladen eines Akkumulators vergleichbar sind. Wollte man diese Effekte zur Steuerung des Ladevorgangs ausnutzen, dann würde der Ladevorgang sehr schnell abgebrochen, obgleich der Akkumulator nicht annähernd vollgeladen ist. Eine Tiefentladung kann unter Umständen sogar zu einer Polaritätsumkehr des Akkumulators führen. Ein tiefentladener Akkumulator verlangt daher zunächst nach einer Formierung, bevor er normal aufgeladen werden kann. Auch dieser Zustand wird bei dem Verfahren nach der Erfindung erkannt.

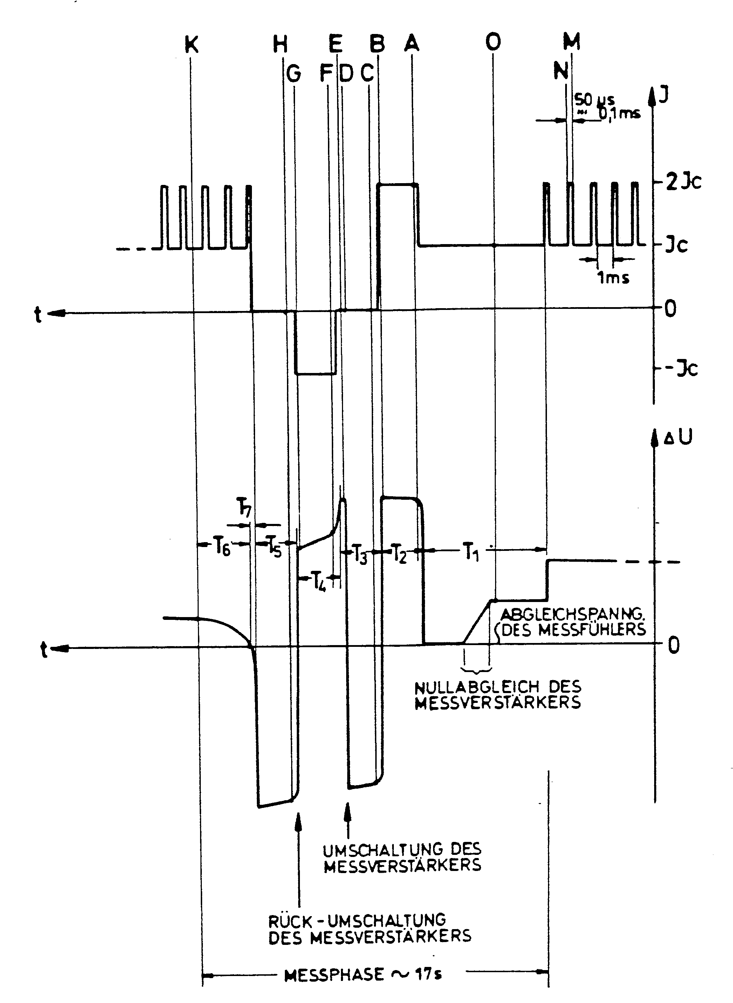

Die Erfindung und weitere Einzelheiten und Vorteile derselben sollen nachfolgend unter Bezugnahme auf die Zeichnung näher erläutert werden.

Die Zeichnung zeigt den zeitlichen Verlauf des Ladestroms bei dem erfindungsgemäßen Ladeverfahren, den sich daraus ergebenden Verlauf der Spannung am Akkumulator sowie die Vielzahl von Meßzeitpunkten O bis K, zu denen die Spannung am Akkumulator gemessen wird.

Dabei zeigt die Spannungskurve lediglich Spannungsdifferenzwerte gegenüber einer Abgleichspannung. Für die Auswertung interessieren nämlich in der Regel nicht die Absolutwerte von Spannungen, sondern nur die Spannungsänderungen am Akkumulator, die von Lade und Belastungsvorgängen hervorgerufen werden. Es findet daher in jeder Meßphase zunächst ein Nullabgleich eines zur Spannungsmessung verwendeten Meßverstärkers statt, womit es zugleich ermöglicht wird, dessen Meßbereich relativ groß zu halten. Aus dem gleichen Grunde ist vorzugsweise vorgesehen, daß die Polarität der dem Meßverstärker zugeführten Akkumulatorspannung in einem in der Meßphase liegenden Belastungsintervall invertiert ausgewertet wird. Aus diesem Grunde ist der Spannungsverlauf im Belastungsintervall in der Zeichnung ins Positive umgeklappt dargestellt.

Fernerhin ist vorteilhaft, wenn die Meßspannungen beim Messen normiert werden, beispielsweise auf die Spannung einer einzelnen Zelle, weil dadurch der apparative Aufwand kleingehalten werden kann, auch wenn Akkumulatoren unterschiedlicher Zellenzahlen zu messen sind. Eine solche Normierung kann an einem Lade- und Prüfgerät mit Hilfe von Schaltern, Steckern oder dergleichen ausgeführt werden, mit denen auch die an die jeweilige Kapazität des zu prüfenden Akkumulators angepaßte Ladestromstärke eingestellt werden kann.

In der Praxis ist vorgesehen, daß ein vollständiger Ladezyklus aus einer Ladephase von beispielsweise etwa 2,5 bis 3 Minuten und einer sich daran anschließenden Meßphase besteht. In der Ladephase wird der Akkumulator mit einem vorgegebenen Nennstrom geladen, der bei Massezellen üblicherweise die Größe des sog. 10-stündigen Ladestroms, abgekürzt $I_{10}$ ist. Eine solche Ladestromstärke würde bei einem Amperestunden-Wirkungsgrad von 100% dazu führen, daß innerhalb von zehn Stunden die Nennkapazität in den Akkumulator "eingeladen" wird. Ein solcher Massezellen-Akkumulator wird dann üblicherweise als vollständig aufgeladen angesehen, wenn er mit diesem Ladestrom $I_{10}$ über 14 Stunden geladen worden ist, d.h. also wenn nominell mit dem "Ladefaktor" 1,4 gearbeitet wurde. Ein Sinterzellenakkumulator kann indessen mit einem Ladestrom aufgeladen werden, der das Zehnfache davon beträgt und der mit $I_C$ bezeichnet wird. Einen solchen Ladevorgang bezeichnet man mit Schnelladung. Ein solcher Zustand ist in der Zeichnung dargestellt, gemäß welchem der Ladestrom $I_C$ beträgt. Im dargestellten Beispiel sind diesem Ladestrom in dem etwa 2,5 bis 3 Minuten lang anhaltenden Ladeimpuls kleine, kurzzeitige Stromimpulse erhöhter Stromstärke überlagert, die bei Sinterzellen eine zeitliche Länge von etwa 50 μs bis 2 ms aufweisen und einen zeitlichen Abstand voneinander haben, der etwa das Zehnfache der Impulslänge beträgt.

Bei Massezellen sind die kleinen, überlagerten Impulse etwa 50 μs bis 0,1 ms lang, während ihr zeitlicher Abstand etwa das Sechzigfache davon beträgt. In der Figur sind die zeitlichen Längen nicht maßstabsgerecht dargestellt. Die Stromstärke dieser kurzzeitigen Impulse liegt bei Massezellenakkumulatoren bei $I_C$ bis $2I_C$, bei Sinterzellenakkumulatoren bei $2I_C$ bis $4I_C$. In der Zeichnung sind die Impulse mit $2I_C$ angenommen.

Bevor die eigentlichen Messungen in der Meßphase stattfinden, werden für eine vorgegebene Zeitdauer $T_1$ von ca. 3 s am Ende des Ladeimpulses die kleinen, überlagerten Impulse erhöhter Stromstärke abgeschaltet, um dem Akkumulator Gelegenheit zu geben, einen Gleichgewichtszustand anzunehmen. In diesem Zeitintervall findet auch der vorerwähnte Nullabgleich des Meßverstärkers statt.

Sodann wird der Akkumulator für eine vorgegebene Zeitdauer von etwa zwei Sekunden mit erhöhtem Strom geladen. Dieser hat bei Sinterzellenakkumulatoren eine Stärke von $2I_C$ (wie dargestellt) bis $4I_C$ und bei Massezellenakkumulatoren eine Stärke von 1 bis $2I_C$. Dieses Intervall ist in der Zeichnung mit $T_2$ bezeichnet.

Daran schließt sich ein Zeitintervall $T_3$ von etwa zwei Sekunden an, in welchem der Akkumulator stromlos ist. Kurz vor dem Ende dieses Intervalls wird im dargestellten Beispiel die Polung des Meßverstärkers umgeschaltet. In der Spannungskurve in der Zeichnung ist dies durch einen Sprung vom Negativen ins Positive in bezug auf die Abgleichspannung dargestellt.

Sodann wird in einem Zeitintervall $T_4$ der Akkumulator mit einem Strom der Größe $-I_C$ belastet.

An die Belastungsphase schließt sich ein Zeitintervall $T_5$ an, in welchem der Akkumulator wieder stromlos ist.

Im Anschluß daran wird der normale Ladebetrieb wieder aufgenommen, in welchem dem Akkumulator der mit den kurzen Impulsen überlagerte Ladestrom der Stärke $I_C$ (bei Sinterzellenakkumulatoren) bzw. $I_{\cdot 3}$ (bei Massezellenakkumulatoren) zugeführt wird.

In der Meßphase werden folgende Messungen ausgeführt:
im Zeitintervall $T_2$ kurz nach Beginn dieses Intervalls eine Spannungsmessung A und am Ende des Intervalls eine Spannungsmessung B;
im ersten stromlosen Zeitintervall $T_3$ eine Spannungsmessung C kurz nach Beginn dieses Intervalls und eine Spannungsmessung D am Ende dieses Intervalls. Außerdem wird nach dem Umpolen des Meßverstärkers im Intervall $T_3$ nochmals die Spannung gemessen, um etwaige Fehler infolge des Umpolens auszuschalten (Messung E);
im Belastungsintervall $T_4$ eine Spannungsmessung F zu einem vorgegebenen Zeitpunkt nach Beginn dieses Intervalls, zu welchem die Spannung auf einen annähernd gleichförmigen Wert abgesunken ist, und eine Messung G am Ende des Belastungsintervalls $T_4$;
im zweiten stromlosen Zeitintervall $T_5$, kurz nach der Rück-Umpolung des Meßverstärkers eine Spannungsmessung H.

Mit "kurz nach" ist hier eine Zeitdauer bezeichnet, die ausreicht, daß die Akkumulatorspannung außerhalb eines stark gekrümmten Bereichs der Spannungskurve erfaßt wird. Sie beträgt vorzugsweise etwa 0,2 s.

Anschließend wird das Ende des stromlosen Zustandes zeitmäßig erfaßt und die Zeitdauer $T_7$ gemessen, die die Akkumulatorspannung benötigt, um die Abgleichspannung wieder zu erreichen.

Nach einer vorgegebenen Zeitdauer $T_6$, die etwa zwei Sekunden beträgt, wird zu einem Zeitpunkt, der nicht mit einem der überlagerten kleinen Ladestromimpulse zusammenfällt, die Akkumulatorspannung mittels einer Messung K nochmals ermittelt. Man kann aber auch ohne Rücksicht auf die zeitliche Lage der kleinen Ladestromimpulse messen, wenn eine Integration der Spannung stattfindet.

Die Meßphase beginnt demnach mit der Abschaltung der kleinen, überlagerten Impulse zu Beginn des Zeitintervalls $T_1$ und endet mit dem Ablauf des Zeitintervalls $T_6$. Sie beträgt etwa 17 Sekunden.

Es wird nun erläutert, wie die gemessenen Spannungswerte und zugehörigen Stromstärken miteinander und im Verhältnis zueinander verarbeitet werden, welche Erkenntnisse daraus gewonnen und welche Folgen für den Ladevorgang des Akkumulators daraus abgeleitet werden.

Aus den mit den Spannungsmessungen O bis K gemessenen Akkumulatorspannungen und den jeweils bekannten zugehörigen Stromstärken werden Innenwiderstände ermittelt.

Aus diesen und unter Zuhilfenahme der ermittelten Widerstände werden Widerstandsdifferenzen und Widerstandsquotienten ermittelt.

Widerstände bzw. Widerstandsdifferenz- und -quotientenwerte werden zwischengespeichert.

Auch werden Differenzwerte zwischen in jeweils zwei aufeinanderfolgenden Meßphasen ermittelten Widerständen berechnet.

Das Alter des Akkumulators wird wie folgt ermittelt:
fabrikneu, wenn im angeladenen (schwach vorgeladenen) Zustand $R_6 \sim 4R_1$ und $R_3 \sim 2R_1$ und $\delta R_1 < 0{,}4R_1$ und der Verlauf von $\delta R_1$ über mehrere Meßphasen kontinuierlich ist,
neu, wenn während des Ladens $R_1 \leq R_6$ und $R_1 \leq R_3$ und $R_4/R_2 \geq 2$,
stark gebraucht, wenn $R_3 > R_6$ und $R_1 > R_3$ und $R_4/R_2 < 2$, oder wenn während des Ladens $R_2 > R_4$,
verbraucht, wenn $R_3$, $R_5$ und $R_6$ jeweils $> 3R_1$ und $R_3/R_6 > 1{,}3$ und während des Ladens $R_2 > R_4$, oder wenn $\delta R_1 > 0{,}4R_1$ und der Verlauf von $\delta R_1$ unregelmäßig ist,
wobei $R_1$ = die Differenz der mit den Messungen B und A ermittelten Innenwiderstände,
$R_2$ = die Differenz der mit den Messungen B und C ermittelten Innenwiderstände,
$R_3$ = die Differenz der mit den Messungen D und C ermittelten Innenwiderstände,
$R_4$ = die Differenz der mit den Messungen E und F ermittelten Innenwiderstände,
$R_5$ = die Differenz der mit den Messungen G und F ermittelten Innenwiderstände,
$R_6$ = die Differenz der mit den Messungen H und

D ermittelten Innenwiderstände,

$\delta R_1$ = die Differenz der in zwei aufeinanderfolgenden Meßphasen mit den Messungen B ermittelten Innenwiderstände.

Der Ladezustand wird wie folgt ermittelt:

voll, wenn bei wenig gebrauchtem Akkumulator $R_3$ = $R_6$, bei gebrauchtem Akkumulator $R_3 > R_6$ und $R_1 \geq R_5$,

annähernd voll, wenn $R_3/R_1 \sim 9 \ldots \infty$ und gleichzeitig $QR_1$, $QR_3$ und $QR_5$ jeweils positiv sind,

teilentladen, wenn $R_3/R_1 \sim 4 \ldots 8$ und gleichzeitig $QR_1$, $QR_3$, $QR_5$ und $QR_6$ jeweils 0 sind, oder $R_1$ negativ ist,

entladen, wenn $R_3/R_1 \sim 1 \ldots 3$ und gleichzeitig $QR_1$, $QR_3$, $QR_5$ und $QR_6$ in der Anfangsphase des Ladevorgangs jeweils negativ sind,

tiefentladen, wenn in der ersten Meßphase $R_1$, $R_2$, $R_3$, $R_4$, $R_5$ und $R_6$ jeweils über akkumulatorspezifisch vorgegebenen Grenzwerten liegen und $R_4 > 4R_0$ und über nachfolgende Meßphasen $QR_1$ anfänglich steigt und dann fällt, oder die Polarität der Akkumulatorspannung entgegengesetzt zu der der Ladespannung ist,

wobei $R_0$ = die Differenz der in zwei aufeinanderfolgenden Meßphasen mit den Messungen O ermittelten Innenwiderstände ist,

$R_1$, $R_3$, $R_5$ und $R_6$ wie in Anspruch 3 definiert sind, und

$QR_1$, $QR_3$, $QR_5$ und $QR_6$ jeweils die Quotienten zwischen zwei in aufeinanderfolgenden Meßphasen ermittelten Werten von $R_1$, $R_3$, $R_5$ und $R_6$ sind.


Temperatur:

Der Akkumulator ist zu kalt, wenn

$R_A > 5R_0$ und $R_1/R_3 > 3$,

wobei $R_A$ der Innenwiderstand gemäß Messung A ist und $R_1$ und $R_3$ wie in Anspruch 2 definiert sind.

Welcher Zustand als "zu kalt" bezeichnet werden muß, hängt vom Fabrikat des Akkumulators ab. Es gibt Fabrikate, bei denen eine Temperatur von 0 °C bereits als zu kalt gilt, während bei anderen Fabrikaten noch bei Temperaturen von etwa -10 °C normal geladen werden kann. Der mittels der Erfindung über Widerstandsmessungen erfaßbare innere Zustand des Akkumulators gibt eine vom Fabrikat unabhängige Aussage ab, die das Ladeprogramm entsprechend beeinflussen kann. Wird der Akkumulator als zu kalt ermittelt, wird der Ladestrom sofort auf die Hälfte reduziert. Ergibt eine anschließende Messung bei diesem Ladestromzustand noch immer ungeeignete Meß- und Auswerteergebnisse, wird der Ladestrom nochmals halbiert. Sollten sich dann noch immer ungeeignete Verhältnisse zeigen, wird das Ladeprogramm als für den betreffenden Akkumulator ungeeignet beurteilt.

Eine Unterscheidung hinsichtlich der Art des Akkumulators läßt sich wie folgt treffen:

Wenn $R_1$ und $R_A$ über einem akkumulatorspezifisch vorgegebenen Grenzwert liegen und zugleich $R_4 > \sim 3R_0$ ist oder die Zellenspannung über einem vorgegebenen Grenzwert liegt, dann handelt es sich um einen Massezellenakkumulator oder um einen Sinterzellenakkumulator mit einer für den eingestellten Ladestrom zu kleiner Kapazität.

Eine Formierung des Akkumulators ist erforderlich, wenn in der Ladeanfangsphase der Verlauf von $QR_1$ sehr stark positiv ist.

Der Akkumulator hat keine Kapazität, wenn $R_4 > 4R_0$ und alle übrigen Widerstände stark über akkumulatorspezifischen Richtwerten liegen. "Keine Kapazität" bedeutet hier, daß der Akkumulator weniger als etwa 40% seiner Nennkapazität aufweist. Mit Kapazität ist hier nicht die augenblicklich im Akkumulator enthaltene Ladung, sondern das Ladungsspeicher- und -abgabevermögen des Akkumulators bezeichnet.

Der Akkumulator zeigt den sog. Memory-Effekt, wie eingangs erläutert, wenn in aufeinanderfolgenden Meßphasen $R_1$ und R4 zurückgehen und zugleich $R_4 > \sim 1,1R_A$, wenn unter Einhaltung von Grenzwerten mit maximal möglichen Strömen geladen wird.

Die genannten Größen $QR_1$, $QR_3$, $QR_5$ und $QR_6$ sind jeweils die Quotienten zwischen zwei in aufeinanderfolgenden Meßphasen ermittelten Werten von $R_1$, $R_3$, $R_5$ und $R_6$.

Das Ende des Ladevorgangs läßt sich für einen neuen Akkumulator durch Überprüfen von $R_0$ festlegen. Wird $R_0$ im Laufe des Ladevorgangs negativ, wird der Ladevorgang beendet. Bei einem gebrauchten Akkumulator erfolgt die Überprüfung anhand von $R_1$. Wird $R_1$ negativ, wird der Ladevorgang beendet. Bei einem stark gebrauchten, "gestreßten" Akkumulator wird $\delta R_6$ geprüft. Wird $\delta R_6$ negativ, dann wird der Ladevorgang beendet. $\delta R_6$ ist die Differenz zwischen zwei in aufeinanderfolgenden Meßphasen ermittelten Widerständen $R_6$.

Wie bereits erwähnt, kann eine Tiefentladung eines Akkumulators zur Folge haben, daß sich seine Polarität umkehrt. Um zu erkennen, ob ein falsch gepolter Akkumulator oder ein tiefentladener Akkumulator vorliegt, wird, wenn eine von der Polarität der Ladespannung abweichende Polarität erkannt wird, der Akkumulator zunächst mit einem kleinen Sensorstrom von etwa $I_C/1000$ geladen. Ein falsch gepolter Akkumulator baut infolge einer solchen Sensorstromladung seine Spannung nicht ab. Dies wird als Hinweis erkannt, daß der Akkumulator falsch gepolt ist. Ein tiefentladener Akkumulator baut hingegen die "falsche Spannung" langsam gegen 0 ab. Dieser Vorgang wird erkannt. Sobald der Akkumulator die Spannung 0 erreicht hat, wird er mit einem etwas höheren Ladestrom von $I_C/100$ geladen, bis er eine Spannung von etwa 0,3 V erreicht hat, und dann wird er mit einem Strom von $I_C 10$ weitergeladen, bis er eine Spannung von 0,8 V erreicht hat. Wird er nun mit diesem Strom weitergeladen, muß er innerhalb einer bestimmten Zeit (etwa 12 min) eine Spannung von 1,2 V erreicht haben. Der Akkumulator ist dann noch "taub", d.h. er besitzt noch kein Speichervermögen. Er muß erst noch formiert werden.

Das Formieren läuft wie folgt ab:

Der Akkumulator wird zyklisch mit einem Ladestrom von $I_{10}$ für eine bestimmte Zeit von beispielsweise drei Minuten geladen und dann auf eine Spannung von 1 V/Zelle entladen. Die Steigung des differentiellen Innenwiderstandes jeder Ladephase der Zyklen wird gemessen. Sie ist anfangs stark positiv und wird dann immer flacher. Zum Schluß ist sie ganz flach. In den Entladephasen wird die Zeit gemessen, bis die Spannung von 1 V/Zelle erreicht ist. Der Lade- und Entladevorgang wird so lange fortgeführt, bis entweder die Zeiten, die notwendig sind, um beim Entladen die Spannung von 1 V pro Zelle zu erreichen, keine Veränderung mehr zeigen, oder der differentielle Innenwiderstand am Ende der Ladephase Null wird.

Ist ein Akkumulator zu kalt, wird er mit vermindertem Ladestrom geladen. Ein Sinterzellenakkumulator wird beispielsweise nur mit $I_{10}$ geladen. Die überlagerten Kurzzeitimpulse versetzen den kalten Akkumulator in die Lage, den vorgenannten Ladestrom aufzunehmen.

Die vorgenannten Kurzzeitimpulse dienen weiterhin der laufenden Überprüfung, ob das eingestellte Ladeprogramm an dem betreffenden Akkumulator ausgeführt werden kann. Zu diesem Zweck wird am Beginn und am Ende eines jeden der Kurzzeitimpulse eine Spannungsmessung ausgeführt (Messungen M und N) und daraus der differentielle Innenwiderstand des Akkumulators ermittelt. Bei einem Akkumulator, der mit einem viel zu hohen Ladestrom geladen wird, steigt der differentielle Innenwiderstand sehr schnell an, so daß daraus ein Hinweis auf einen falschen Akkumulator abgeleitet werden kann.

Auch wenn beabsichtigt ist, ein Schnelladeprogramm auszuführen, wird in der Anfangsphase aus Sicherheitsgründen zunächst mit dem Ladestrom $I_C$ geladen. Bereits in der ersten Meßphase wird die Prüfung ausgeführt, ob es sich bei dem angeschlossenen Akkumulator um einen Massezellenakkumulator oder um einen Sinterzellenakkumulator handelt. Es wird dann unmittelbar nach der ersten Meßphase auf Schnelladebetrieb umgeschaltet, wenn sich herausgestellt hat, daß der angeschlossene Akkumulator ein Sinterzellenakkumulator ist. Ansonsten wird das Ladeprogramm mit dem Ladestrom $I_C$ fortgesetzt.

Gleiches gilt auch, wenn der angeschlossene Akkumulator sehr kalt ist. Wie bereits ausgeführt, kann auch ein schnelladefähiger Akkumulator unter Umständen nicht schnelladefähig sein, nämlich wenn er zu kalt ist. Das Ladeprogramm mit reduziertem Ladestrom wird dann so lange aufrechterhalten, bis aufgrund der Messungen in den Meßphasen ermittelt worden ist, daß der Akkumulator aufgrund Erwärmung schnelladefähig geworden ist.

Es versteht sich, daß manche der Kriterien, die für die Messungen ausgenutzt werden, davon ausgehen, daß der Ladestrom, der eingestellt worden ist, entsprechend der Kapazität des Akkumulators gewählt ist. Ein zu dem eingestellten Ladestrom passender Akkumulator zeigt im Normalzustand kein Fehlverhalten, reagiert aber in spezieller Weise, wenn er beispielsweise tiefentladen ist, zu kalt ist, einen Elektrodenschluß zeigt oder verbraucht ist. Ein zu dem eingestellten Ladestrom nicht passender Akkumulator, der beispielsweise eine zu kleine Nennkapazität hat, ansonsten aber keine außergewöhnlichen Zustände, wie beispielsweise Tiefentladung oder zu kalte Temperatur zeigt, wird als solcher von dem erfindungsgemäßen Lade- und Prüfverfahren ebenfalls erkannt, und daraus werden die entsprechenden Maßnahmen abgeleitet, d.h. der Ladevorgang wird mit reduziertem Ladestrom fortgeführt oder ggf. ganz abgebrochen.

Besonders vorteilhaft ist es, wenn dem Ladestrom die erwähnten Kurzzeitimpulse überlagert werden, weil mit Hilfe dieser Impulse der differentielle Innenwiderstand des Akkumulators fortlaufend überwacht werden kann, d.h. auch innerhalb der zeitlich längeren (2,5 bis 3 Minuten) Ladestromimpulse. in denen ansonsten, wie auch im Stand der Technik, keine Messungen ausgeführt würden.

Soweit in der Beschreibung und in den Ansprüchen auf akkumulatorspezifisch vorgegebene Grenzwerte Bezug genommen ist, sei hierzu erläutert, daß solche Grenzwerte aus Datenblättern der Akkumulatorhersteller zu entnehmen sind bzw. aus diesen errechnet werden können.

## Ansprüche

1. Verfahren zum Laden und gleichzeitigen Prüfen des Zustandes eines Nickelcadmium-Akkumulators mit einem pulsierenden Ladegleichstrom rechteckigen Impulsverlaufs, der Abschnitte kleiner Stromstärke und Abschnitte hoher Stromstärke aufweist, und mit zyklisch eingeschobenen Meßphasen mit Entladeintervallen vergleichsweise kurzer Dauer, wobei zu Beginn und im vorgegebenen zeitlichen Abstand nach Beginn der Abschnitte hoher Stromstärke jeweils die Akkumulatorspannung gemessen und die Differenz der gemessenen Spannungswerte zur Steuerung des Ladevorgangs verwendet werden, **gekennzeichnet durch** folgende Merkmale:

a) jeder Ladestromimpuls besteht aus einem Rechteckimpuls einer Nennstromstärke $I_N$,

b) kurz vor dem Ende des Ladestromimpulses wird die Akkumulatorspannung gemessen (Messung O) und als Abgleichspannung gespeichert,

c) sodann wird der Akkumulator für eine vorgegebene Zeitdauer ($T_2$) von etwa 1 bis 2 Sekunden mit der Stromstärke $2I_C$ geladen, wobei $I_C$ die Kapazität des Akkumulators in A.h/1h ist, und es wird die Akkumulatorspannung etwa 0,2 s nach Beginn und am Ende dieser Zeitdauer ($T_2$) gemessen (Messungen A und B),

d) anschließend wird der Akkumulator für eine vorgegebene Zeitdauer ($T_3$) von etwa 1 bis 2 Sekunden stromlos gemacht und es wird seine Spannung etwa 0,2 s nach Beginn und am Ende dieser Zeitdauer ($T_3$) gemessen (Messungen C und D),

e) sodann wird der Akkumulator für eine vorgegebene Lastperiode ($T_4$) von etwa 1 bis 2 Sekunden mit einem Laststrom der Größe $-I_C$ belastet und es wird die Akkumulatorspannung unmittelbar vor dem Beginn und etwa 0,2 s danach sowie am Ende der Lastperiode ($T_4$) gemessen (Messungen E, F und G),

f) anschließend wird der Akkumulator erneut für eine vorgegebene Zeitdauer ($T_5$) von etwa 1 bis 2 Sekunden stromlos gemacht, und es wird seine Spannung etwa 0,2 s nach Beginn dieser Zeitdauer ($T_5$) gemessen (Messung H),

g) sodann wird der Ladevorgang mit dem nachfolgenden Ladestromimpuls wieder aufgenommen,

h) aus den gemessenen Spannungswerten und den dabei herrschenden Stromstärken werden die jeweiligen Innenwiderstände des Akkumulators ermittelt, und

i) die in einer Meßphase ermittelten Innenwiderstände werden zueinander in Beziehung gesetzt und in aufeinanderfolgenden Meßphasen in einander entsprechenden Messungen ermittelte Innenwiderstände werden zueinander in Beziehung gesetzt, daß sich Aussagen über Güte, Alter, Ladezustand, Temperatur und Art des Akkumulators ergeben.

2. Verfahren nach Anspruch 1, **dadurch gekennzeichnet,** daß das Alter des Akkumulators wie folgt ermittelt wird:

fabrikneu, wenn im angeladenen (schwach vorgeladenen) Zustand $R_6 \sim 4R_1$ und $R_3 \sim 2R_1$ und $\delta R_1 < 0,4R_1$ und der Verlauf von $\delta R_1$ über mehrere Meßphasen kontinuierlich ist,

neu, wenn während des Ladens $R_3 \leq R_6$ und $R_1 \leq$ $R_3$ und $R_4/R_2 \geq 2$,

stark gebraucht, wenn $R_3 > R_6$ und $R_1 > R_3$ und $R_4/R_2 < 2$, oder wenn während des Ladens $R_2 > R_4$,

verbraucht, wenn $R_3$, $R_5$ und $R_6$ jeweils $> 3R_1$ und $R_3/R_6 > 1,3$ und während des Ladens $R_2 > R_4$, oder wenn $\delta R_1 > 0,4R_1$ und der Verlauf von $\delta R_1$ unregelmäßig ist,

wobei $R_1$ = die Differenz der mit den Messungen B und A ermittelten Innenwiderstände,

$R_2$ = die Differenz der mit den Messungen B und C ermittelten Innenwiderstände,

$R_3$ = die Differenz der mit den Messungen D und C ermittelten Innenwiderstände,

$R_4$ = die Differenz der mit den Messungen E und F ermittelten Innenwiderstände,

$R_5$ = die Differenz der mit den Messungen G und F ermittelten Innenwiderstände,

$R_6$ = die Differenz der mit den Messungen H und D ermittelten Innenwiderstände,

$\delta R_1$ = die Differenz der in zwei aufeinanderfolgenden Meßphasen mit den Messungen B ermittelten Innenwiderstände.

3. Verfahren nach Anspruch 1, **dadurch gekennzeichnet,** daß der Ladezustand des Akkumulators wie folgt ermittelt wird:

a) in ca. 30%-Abschnitten an den Wendepunkten des Verlaufs der Widerstandsverhältnisse von $R_1$ bis $R_6$,

b) innerhalb der 30%-Abschnitte in 10%-Abschnitten durch die Steigung des Verlaufs der Widerstandsverhältnisse von $R_1$ bis $R_6$,

wobei die Widerstandsverhältnisse von $R_1$ bis $R_6$ jeweils aus den Innenwiderständen gebildet werden, die in aufeinanderfolgenden Meßphasen mit einander entsprechenden Messungen und rechnerischen Auswertungen ermittelt werden.

4. Verfahren nach einem der Ansprüche 1 bis 3, **dadurch gekennzeichnet,** daß der Ladezustand des Akkumulators wie folgt ermittelt wird:

voll, wenn bei wenig gebrauchtem Akkumulator $R_3 = R_6$, bei gebrauchtem Akkumulator $R_3 > R_6$ und $R_1 \geq R_5$,

annähernd voll, wenn $R_3/R_1 \sim 9 \dots \infty$ und gleichzeitig $QR_1$, $QR_3$ und $QR_5$ jeweils positiv sind,

teilentladen, wenn $R_3/R_1 \sim 4 \dots 8$ und gleichzeitig $QR_1$, $QR_3$, $QR_5$ und $QR_6$ jeweils 0 sind, oder $R_1$ negativ ist,

entladen, wenn $R_3/R_1 \sim 1 \dots 3$ und gleichzeitig $QR_1$, $QR_3$, $QR_5$ und $QR_6$ in der Anfangsphase des Ladevorgangs jeweils negativ sind,

tiefentladen, wenn in der ersten Meßphase $R_1$, $R_2$, $R_3$, $R_4$, $R_5$ und $R_6$ jeweils über akkumulatorspezifisch vorgegebenen Grenzwerten liegen und $R_4 > 4R_0$ und über nachfolgende Meßphasen $QR_1$ anfänglich steigt und dann fällt, oder die Polarität der Akkumulatorspannung entgegengesetzt zu der der Ladespannung ist,

wobei $R_0$ = die Differenz der in zwei aufeinanderfolgenden Meßphasen mit den Messungen O ermittelten Innenwiderstände ist,
$R_1$, $R_3$, $R_5$ und $R_6$ wie in Anspruch 3 definiert sind, und
$QR_1$, $QR_3$, $QR_5$ und $QR_6$ jeweils die Quotienten zwischen zwei in aufeinanderfolgenden Meßphasen ermittelten Werten von $R_1$, $R_3$, $R_5$ und $R_6$ sind.

5. Verfahren nach einem der Ansprüche 1 bis 4, dadurch gekennzeichnet, daß ein tiefgekühlter Zustand des Akkumulators wie folgt ermittelt wird:
$R_A > 5R_0$ und $R_1/R_3 > 3$,
wobei $R_A$ der Innenwiderstand gemäß Messung A ist und $R_1$ und $R_3$ wie in Anspruch 2 definiert sind.

6. Verfahren nach einem der vorhergehenden Ansprüche, dadurch gekennzeichnet, daß der Zustand, in welchem eine Formierung erforderlich ist, aus der Tatsache ermittelt wird, daß in der Ladeanfangsphase $QR_1$ sehr stark zunimmt, wobei $QR_1$ wie in Anspruch 3 definiert ist.

7. Verfahren nach einem der vorhergehenden Ansprüche, dadurch gekennzeichnet, daß die Art des Akkumulators wie folgt ermittelt wird:
es liegt ein Massezellenakkumulator oder ein für den Ladestrom eine zu kleine Kapazität aufweisender Sinterzellenakkumulator vor, wenn $R_1$ und $R_A$ über einem akkumulatorspezifisch vorgegebenen Grenzwert liegen, $R_4 > 3R_0$, oder die Zellenspannung über einem vorgegebenen Grenzwert liegt,
wobei $R_1$, $R_4$ und $R_0$ wie in Anspruch 2 definiert sind.

8. Verfahren nach einem der vorhergehenden Ansprüche, dadurch gekennzeichnet, daß der Zustand, wonach der Akkumulator keine Kapazität hat, aus der Tatsache ermittelt wird, daß $R_4 > 4R_0$, und alle übrigen Widerstände stark überhöht gegenüber akkuspezifischen Richtwerten liegen, wobei $R_4$ und $R_0$ wie in Anspruch 2 definiert sind.

9. Verfahren nach einem der vorhergehenden Ansprüche, dadurch gekennzeichnet, daß der Zustand, wonach der Akkumulator einen sog. Memory-Effekt aufweist, aus der Tatsache ermittelt wird, daß in aufeinanderfolgenden Meßphasen $R_1$ und $R_4$ abnehmen und $R_4 > \sim 1,1R_A$, wobei $R_1$, $R_4$ und $R_A$ wie in Anspruch 2 bzw. 5 definiert sind, wenn unter Einhaltung von Grenzwerten mit maximal möglichen Strömen geladen wird.

10. Verfahren nach einem der vorhergehenden Ansprüche, dadurch gekennzeichnet, daß nach Wiederaufnahme des Ladevorgangs die Akkumulatorspannung mit vorgegebenem zeitlichen Abstand ($T_5$) von ca. 2 Sekunden nach Überschreiten der Abgleichspannung gemessen wird (Messung K) und daß aus diesem Innenwiderstand ($R_K$) eine Aussage über den Abnutzungsgrad (Alter) des Akkumulators abgeleitet wird.

11. Verfahren nach Anspruch 10, dadurch gekennzeichnet, daß die Zeitdauer ($T_7$) zwischen dem Zeitpunkt des Beginns eines Ladeimpulses nach stromlosem Zustand und dem Wiedererreichen der Abgleichspannung gemessen wird und aus dieser Zeitdauer ($T_7$) eine Aussage über das Alter des Akkumulators abgeleitet wird.

12. Verfahren nach einem der Ansprüche 10 und 11, dadurch gekennzeichnet, daß aus der Charakteristik des Verlaufs der Differenzen ($\delta R_K$) der in aufeinanderfolgenden Meßphasen mit den Messungen K ermittelten Innenwiderstände ($R_K$) eine Aussage über den Ladezustand des Akkumulators gewonnen wird.

13. Verfahren nach einem der vorhergehenden Ansprüche, dadurch gekennzeichnet, daß dem Ladestromimpuls in kurzen zeitlichen Abständen sehr kurze Ladestromimpulse einer höheren Stromstärke überlagert sind, deren Länge in der Größenordnung von 50 $\mu$s bis 2 ms liegt, zu Beginn und nach dem Ende eines jeden dieser kurzen Ladestromimpulse die Akkumulatorspannung gemessen wird (Messungen M und N) und vor dem Ende des Ladestromimpulses in dem Akkumulator ein Gleichgewichtszustand hergestellt wird, in dem die kurzen, überlagerten Ladestromimpulse für eine vorgegebene Zeitdauer ($T_1$) abgeschaltet werden, kurz vor deren Ende die Messung O ausgeführt wird, und daß aus den Messungen M und N der differentielle Innenwiderstand des Akkumulators laufend ermittelt wird und der Ladevorgang abgebrochen wird, wenn der differentielle Innenwiderstand einen akkumulatorspezifisch vorgegebenen Grenzwert übersteigt.

14. Verfahren nach Anspruch 13, dadurch gekennzeichnet, daß die Zeitabstände zwischen den überlagerten, kurzen Impulsen etwa 10 bis 60 mal so groß sind, wie die Länge der kurzen Impulse.

15. Verfahren nach einem der vorhergehenden Ansprüche, dadurch gekennzeichnet, daß beim Laden von Sinterzellen $I_N = I_C$ ist.

16. Verfahren nach einem der Ansprüche 14 und 15, dadurch gekennzeichnet, daß beim Laden von Sinterzellen die überlagerten kurzen Ladestromimpulse die Stromstärke $2I_C$ bis $4I_C$ haben.

17. Verfahren nach einem der Ansprüche 1 bis 14, dadurch gekennzeichnet, daß beim Laden von Massezellen $I_N = I_{10}$ ist.

18. Verfahren nach Anspruch 13 oder 14 und 17, dadurch gekennzeichnet, daß beim Laden von Massezellen die überlagerten kurzen Ladestromimpulse eine Stromstärke von $I_C$ bis $2I_C$ haben.

19. Verfahren nach einem der vorhergehenden Ansprüche, dadurch gekennzeichnet, daß nach dem Anschließen eines Akkumulators in jedem Falle zunächst mit einem Ladestrom $I_N$ der Stärke $I_{10}$ geladen wird.

20. Verfahren nach einem der vorhergehenden Ansprüche, **dadurch gekennzeichnet,** daß vor dem Zuführen des gepulsten Ladegleichstroms der Akkumulator mit einem sehr kleinen (Sensor-) Strom von etwa $I_C/1000$ geladen und im Falle ungleicher Polaritäten von Akkumulator-und Ladespannung die zeitliche Entwicklung der Akkumulatorspannung als Folge der Aufladung mit dem Sensorladestrom überwacht wird, und daß im Falle, daß die Akkumulatorspannung allmählich abnimmt, der Ladevorgang mit dem Sensorstrom so lange fortgesetzt wird, bis die Akkumulatorspannung 0 erreicht ist, und anschließend mit einem erhöhten Ladestrom von $I_C/100$ weitergeladen wird, bis 0,3 V/Zelle erreicht sind, sodann mit $I_C/10$ weitergeladen wird, bis eine Akkumulatorspannung von etwa 0,8 V/Zelle erreicht ist, bevor der Ladevorgang mit einem Formieren des Akkumulators fortgesetzt wird, während im Falle, daß beim Laden mit Sensorstrom die Akkumulatorspannung nicht abnimmt, der Ladevorgang abgebrochen wird.

21. Verfahren nach einem der vorhergehenden Ansprüche, **dadurch gekennzeichnet,** daß vor den Spannungsmessungen in der Meßphase zunächst ein Nullabgleich eines Meßverstärkers mit dieser Akkumulatorspannung ausgeführt wird und die Akkumulatorspannungen dann gegen diese Abgleichspannung gemessen werden.

22. Verfahren nach einem der vorhergehenden Ansprüche, **dadurch gekennzeichnet,** daß während der Belastungsperiode ($T_4$) die dem Meßverstärker zugeführte Akkumulatorspannung invertiert ausgewertet wird.

50 μs
≈ 0,1ms

J

2 Jc

Jc

1ms

0

-Jc

ΔU

T7

T6

T5

T4

T3

T2

T1

ABGLEICHSPANNG.
DES MESSFÜHLERS

0

NULLABGLEICH DES
MESSVERSTÄRKERS

UMSCHALTUNG DES
MESSVERSTÄRKERS

RÜCK-UMSCHALTUNG
DES MESSVERSTÄRKERS

MESSPHASE ~ 17s